# EUROPÄISCHE PATENTANMELDUNG

(11) **EP 2 144 485 A1**
(43) Veröffentlichungstag der Anmeldung: **13.01.2010**
(21) Anmeldenummer: 08012517.2
(22) Anmeldetag: 10.07.2008
(51) Int. Cl.: H05K 7/14, H02B 1/00

(54) **Vorrichtung zum Befestigen von Baugruppen**

(71) Anmelder: Siemens Aktiengesellschaft, 80333 München (DE)
(72) Erfinder: Chowaniec, Michael, 09126 Chemnitz (DE)

(57) **Zusammenfassung**

Die Erfindung bezieht sich auf eine Vorrichtung (1) zum Befestigen von Baugruppen (21, 22, 23) umfassend, eine sich längs erstreckende Schiene (2), einen an einer ersten seitlichen Kante der Schiene (2) angeordneten ersten Schenkel (3), einen an einer zweiten Kante der Schiene (2) seitlich angeordneten zweiten Schenkel (4), wobei der erste und der zweite Schenkel (3, 4) je ein erstes und ein zweites Befestigungsmittel (7, 8) zur Aufnahme einer ersten Baugruppe (21) aufweisen. Um die Möglichkeit bereitzustellen, unterschiedliche Baugruppensysteme auf einer einheitlichen Montageschiene platzieren zu können, wurde zwischen dem ersten Schenkel (3) und dem zweiten Schenkel (4) parallel verlaufend zu diesen ein dritter Schenkel (5) mit einem dritten Befestigungsmittel (9) zur Aufnahme einer zweiten Baugruppe (22) angeordnet.

## Beschreibung

Die Erfindung betrifft eine Vorrichtung zur Befestigung von Baugruppen, umfassend eine sich längs erstreckende Schiene, einem an einer ersten Kante der Schiene angeordneten ersten Schenkel, einen an einer zweiten Kante der Schiene seitlich angeordneten zweiten Schenkel, wobei der erste und der zweite Schenkel je ein erstes und ein zweites Befestigungsmittel zur Aufnahme einer ersten Baugruppe aufweisen.

Eine derartige Vorrichtung wird bereits beispielsweise in der Automatisierungstechnik, insbesondere in Schaltschränken, zum Befestigen von Baugruppen verwendet. Dabei ist die Schiene als eine sogenannte Hutprofilschiene ausgestaltet. Auf dieser Hutprofilschiene können Baugruppen, welche einer bestimmten Gerätefamilie angehören, angeordnet werden. Dazu werden sie mit einem ersten Verrastmechanismuses, beispielsweise zuerst an einer oberen Kante eingehakt und dann mittels eines weiteren Verrastmechanismusses mit der unteren Kante der Hutprofilschiene verrastet und somit lösbar befestigt. Nachteilig hieran ist, dass auf den Hutprofilschienen, welche ein festes Maß aufweisen, nur Baugruppen einer Gerätefamilie gesteckt bzw. aufgerastet werden können.

Nun werden in der Automatisierungstechnik aber Geräte von unterschiedlicher Größe und von unterschiedlichem Gewicht eingesetzt. Dabei werden meist kleine leichtere Gerätefamilien auf 35 mm Standard-Hutschienen aufgerastet, während große, schwerere Baugruppen aus einer anderen Gerätefamilie aus mechanischen Gründen auf Spezialprofilen befestigt werden müssen. Nachteilig hieran ist, dass mehrere Hutprofilschienen mit unterschiedlicher Größe nebeneinander oder übereinander zum Befestigen unterschiedlicher Gerätefamilien angeordnet werden müssen.

Es ist daher die Aufgabe der Erfindung, eine Vorrichtung anzugeben, welche es ermöglicht, Baugruppen unterschiedlicher Größe und unterschiedlichen Gewichtes bzw. Baugruppen von verschiedenen Gerätefamilien auf einer zusammenhängenden Vorrichtung zu befestigen.

Die Aufgabe wird dadurch gelöst, dass zwischen dem ersten Schenkel und dem zweiten Schenkel parallel verlaufend zu diesen ein dritter Schenkel mit einem dritten Befestigungsmittel zur Aufnahme einer zweiten Baugruppe angeordnet ist. Gehört beispielsweise die erste Baugruppe einer ersten Gerätefamilie an und die zweite Baugruppe einer zweiten Gerätefamilie an, wobei die erste Gerätefamilie sich dadurch auszeichnet, dass ihre Baugruppen kleiner und leichter sind als die Baugruppen der zweiten Gerätefamilie, so können nun die beiden unterschiedlichen Baugruppen auf oder an einer gemeinsamen Vorrichtung befestigt werden. Zur ersten Gerätefamilie könnte beispielsweise ein Niederspannungsschütz gehören und zur zweiten Gerätefamilie ein dementsprechend stärker ausgestalteter Motorstarter. Erfindungsgemäß können nun auf einer Vorrichtung beispielsweise ein größerer Motorstarter mittels den Befestigungsmitteln am ersten und zweiten Schenkel befestigt werden und eine zweite Art von kleineren Baugruppen aus der zweiten Gerätefamilie kann dann mittels der Befestigungsmittel des ersten und des dritten Schenkels ebenfalls auf ein und derselben Vorrichtung befestigt werden. Hierbei dient jeweils das erste Befestigungsmittel des ersten Schenkels für beide Arten von Baugruppen als gemeinsames Befestigungsmittel bzw. gemeinsamer Schenkel. Das erste und das zweite Befestigungsmittel des ersten und zweiten Schenkels bilden also zusammen die Befestigung für die erste Art von Baugruppen und das erste Befestigungsmittel mit seinem ersten Schenkel und das dritte Befestigungsmittel mit seinem dritten Schenkel bilden dabei die Befestigung für die zweite Art von Baugruppen. Somit ist eine Vorrichtung bzw. ein Profilsystem bereitgestellt, das sowohl die Montage von kleinen, als auch von großen Baugruppen in Kombination zulässt, ohne sich dabei von bereits etablierten Standards zu entfernen. Eine gemeinsame Ausrichtung aller Baugruppen an einer Anlagenkante wird dabei als Vorteil gesehen.

In einer Ausgestaltungsform der Erfindung wird ein vierter Schenkel parallel verlaufend zum zweiten Schenkel zwischen dem zweiten und dem dritten Schenkel angeordnet, wobei eine zum vierten Schenkel gerichtete erste Fläche des zweiten Schenkels zusammen mit einer der ersten Fläche gegenüberstehend angeordneten zweiten Fläche des vierten Schenkels ein viertes Befestigungsmittel zum Befestigen eines Zusatzelementes bildet. Ein Zusatzelement kann dabei eine Ergänzungsplatte, beispielsweise für ein weiteres zusätzliches Hutschienenprofil, eine Schirmauflage für beispielsweise die störsichere Schirmung von empfindlichen Geräten, ein Bereitstellungselement für Zusatzklemmen usw. sein.

In einer ersten Ausgestaltungsvariante sind die sich gegenüberstehend angeordneten erste und zweite Fläche als eine das Gegenstück zu einem Schraubelement bildende Aufnahme ausgestaltet. Vorzugsweise weisen die erste und die zweite Fläche dabei eine Gewindestruktur auf, so dass beispielsweise in den durch die Flächen gebildeten Zwischenraum Schraubelemente zur Befestigung des Zusatzelementes eingeschraubt werden können.

In einer alternativen Ausgestaltungsvariante sind die sich gegenüberstehend angeordneten erste und zweite Fläche als eine das Gegenstück zu einem Verrastelement bildende Aufnahme ausgestaltet. Die erste und die zweite Fläche sind dabei beispielsweise als eine Art Sägezahnoberflächenprofil ausgestaltet, so dass sich zur Befestigung des Zusatzelementes Verraststifte in den Zwischenraum stecken lassen.

In einer weiteren Ausgestaltungsform liegt das Zusatzelement zumindest abschnittsweise formschlüssig auf dem zweiten Befestigungsmittel auf. Das Befestigungsmittel bildet dabei eine vorzugsweise ebene Auflagefläche und kann beispielsweise das Zusatzelement mit auf die Auflagefläche aufgebrachten Kontaktkleber weiter stabilisieren.

Weitere Vorteile und Ausgestaltungsmerkmale werden anhand der Zeichnung in einem Ausführungsbeispiel erläutert. Es zeigen:
- FIG 1: eine Vorrichtung zum Befestigen von Baugruppen mit Baugruppen in unterschiedlichen Baugrößen einer perspektivischen Ansicht,
- FIG 2: ein perspektivischer Schnitt durch das Profil der Vorrichtung und
- FIG 3: ein perspektivischer Schnitt des Profils der Vorrichtung mit Zusatzelement.

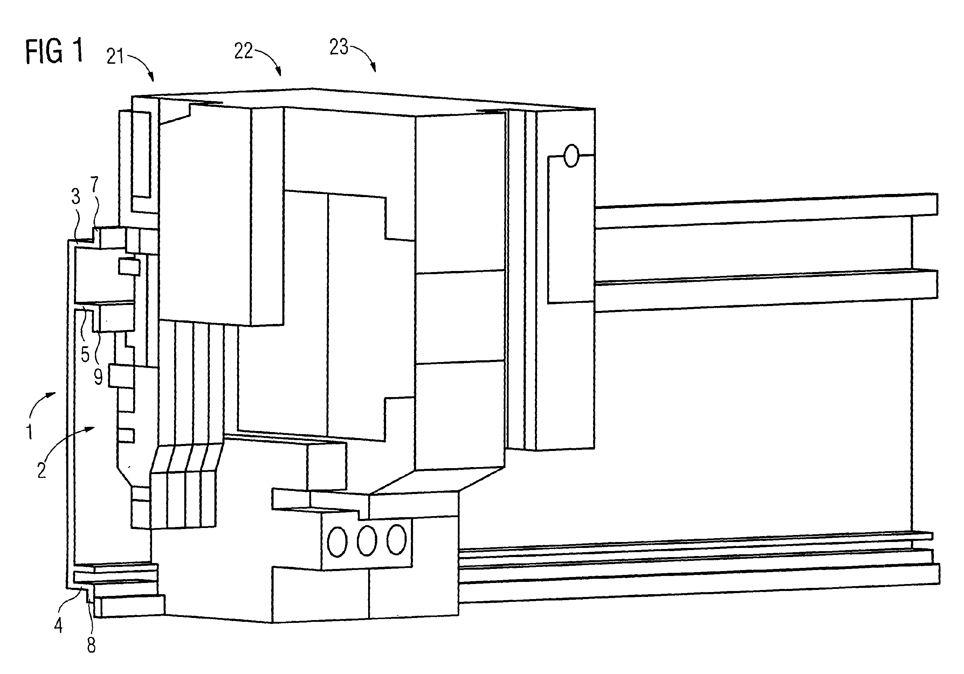

Gemäß Figur 1 ist eine Vorrichtung 1 zum Befestigen von Baugruppen dargestellt. Dabei umfasst die Vorrichtung 1 eine sich längs erstreckende Schiene 2, einen an einer ersten seitlichen Kante der Schiene 2 angeordneten ersten Schenkel 3, einen an einer zweiten Kante der Schiene 2 seitlich angeordneten zweiten Schenkel 4, wobei der erste Schenkel 3 und der zweite Schenkel 4 je ein erstes und ein zweites Befestigungsmittel 7, 8 aufweisen. Zwischen dem ersten Schenkel 3 und dem zweiten Schenkel 4 ist ein dritter Schenkel 5 mit einem dritten Befestigungsmittel 9 angeordnet. Eine erste Baugruppe 21 gehört zu einer ersten Gerätefamilie, welche derartig konstruiert ist, dass sie mit ihrem Verrastmechanismus auf eine 35-mm-Hutprofilschiene aufgerastet werden kann. Die 35-mm-Hutprofilschiene wird gemäß Vorrichtung 1 aus dem ersten Schenkel 3 mit seinem ersten Befestigungsmittel 7 und dem dritten Schenkel 5 mit seinem dritten Befestigungsmittel 9 gebildet.

In diesem Beispiel ist unter den Befestigungsmitteln die klassische Hutprofilschienenform zu verstehen. Dabei sind die Enden der Schenkel rechtwinklig abgebogen.

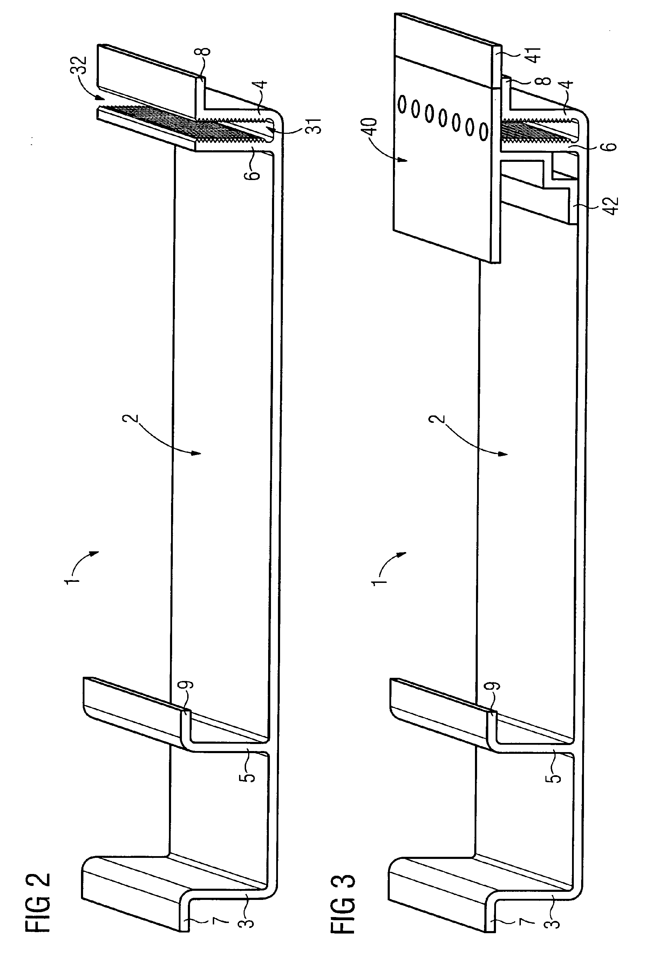

Die zweite Baugruppe 22 ist als ein Motorstarter ausgestaltet und somit gilt sie als eine schwere Baugruppe. Um diese zweite Baugruppe 22 sicher zu befestigen, ist sie zum einen mit dem ersten Befestigungsmittel 7 des ersten Schenkels 3 und zum anderen mit dem Befestigungsmittel 8 des zweiten Schenkels 4 verrastet. Die Schiene 2 mit dem ersten Schenkel 3 und dem zweiten Schenkel 4 mit den ihr zugehörigen Befestigungsmitteln 7 und 8 bildet dabei wiederum ein Hutprofilschienensystem. Die Vorrichtung 1 besteht also aus einem Inneren, kleineren Tragprofil und einem äußeren, größeren Tragprofil. Gemäß Figur 2 ist ein Ausschnitt der Vorrichtung 1 aus einer Profilschiene mit dem inneren und dem äußeren Tragprofil dargestellt. In Ergänzung zu Figur 1 wird der konstruktive Aufbau der Vorrichtung 1 gemäß Figur 2 nochmals erläutert. An einer Schiene 2 ist an einer ersten seitlichen Kante der erste Schenkel 3 rechtwinklig zur Fläche der Schiene 2 angeordnet. Das erste Befestigungsmittel 7 wird dabei durch rechtwinkliges Abbiegen des Endes des Schenkels 3 erreicht. Im Abstand von 35 mm ist zum ersten Schenkel 3 der dritte Schenkel 5 auf der Schiene 2 ebenfalls rechtwinklig zur Fläche der Schiene 2, parallel zum ersten Schenkel 3 angeordnet. Das dritte Befestigungsmittel 9, bei dem dritten Schenkel 5, wird hier ebenfalls wieder durch rechtwinkliges Abbiegen des Endes des dritten Schenkels 5 erreicht. Durch zueinander gegenläufiges Abwinkeln der Enden des ersten Schenkels 3 und des dritten Schenkels 5 entsteht die klassische Hutprofil-Form. Auf dieser Hutprofil-Form können die Baugruppen der ersten, kleineren, leichteren Gerätefamilie aufgerastet werden.

An der zweiten seitlichen Kante der Schiene 2 ist seitlich der zweite Schenkel 4 rechtwinklig zu der Fläche der Schiene 2 angeordnet. Das zweite Befestigungsmittel 8 des zweiten Schenkels 4 wird wiederum durch rechtwinkliges Abbiegen des Endes des zweiten Schenkels 4 erreicht. Mit dem ersten Schenkel 3 und seinem ersten Befestigungsmittel 7 und dem zweiten Schenkel 4 mit seinem zweiten Befestigungsmittel 8 ist nun ein zweites "äußeres" Tragprofil bereitgestellt. Dieses Tragprofil umfasst eine Spannweite von ca. 150 mm. Das abgebogene Ende des dritten Schenkels 5 weist dabei in die gleiche Richtung wie das abgebogene Ende des zweiten Schenkels 4.

Ergänzend zu den drei Befestigungsmitteln 7, 8, 9 ist rechtwinklig zu der Fläche der Schiene 2 nahe dem zweiten Schenkel 4 ein vierter Schenkel 6 angeordnet. Der vierte Schenkel 6 weist in diesem Beispiel allerdings kein abgebogenes Ende auf. Eine dem vierten Schenkel 6 zugewandte erste Innenfläche 31 des zweiten Schenkels 4 weist eine gewindeähnliche Struktur auf. Ebenfalls weist eine zweite Fläche 32 des vierten Schenkels 6, welche dem zweiten Schenkel 4 zugewandt ist, auch eine gewindeähnliche Struktur auf. In diesen Zwischenraum, welcher aus der zweiten Fläche 32 des vierten Schenkels 6 und der ersten Fläche 31 des zweiten Schenkels 4 gebildet wird, können zur Befestigung eines in Figur 3 gezeigten Zusatzelementes 40 vorzugsweise 6-mm-Schrauben eingeschraubt werden.

Gemäß Figur 3 ist die Vorrichtung 1 um ein Zusatzelement 40 erweitert dargestellt. An das zweite Befestigungsmittel 8 ist eine zusätzliche Abschlussleiste 41 für das Zusatzelement 40 angeordnet. Das Zusatzelement 40 liegt dabei mit einer seiner Flächen formschlüssig auf der ebenen Fläche des zweiten Befestigungselements 8 auf. Das Zusatzelement 40 beschreibt im Wesentlichen eine T-Form, wobei senkrecht zu einer Hauptfläche des Zusatzelements 40 ein Steg mit einem mehrfach rechtwinklig abgebogenen Widerlager 42 angeordnet ist. Das Widerlager 42 liegt ebenfalls formschlüssig und eben auf der Fläche der Schiene 2 auf und bildet dabei ein konstruktives Element zur passgenauen und stabilen Einbindung des Zusatzelements 40 an den vierten Schenkel 6 und auf die Auflagefläche des zweiten Befestigungsmittels 8.

## Patentansprüche

1. Vorrichtung (1) zur Befestigung von Baugruppen (21, 22, 23) umfassend, eine sich längs erstreckende Schiene (2), einen an einer ersten seitlichen Kante der Schiene (2) angeordneten ersten Schenkel (3), einem an einer zweiten Kante der Schiene (2) angeordneten zweiten Schenkel (4), wobei der erste und der zweite Schenkel (3, 4) je ein erstes und ein zweites Befestigungsmittel (7, 8) zur Aufnahme einer ersten Baugruppe (21) aufweisen,
**dadurch gekennzeichnet, dass** zwischen dem ersten Schenkel (3) und dem zweiten Schenkel (4) parallel verlaufend zu diesen ein dritter Schenkel (5) mit einem dritten Befestigungsmittel (9) zur Aufnahme einer zweiten Baugruppe (22) angeordnet ist.

2. Vorrichtung (1) nach Anspruch 1, wobei ein vierter Schenkel (6) parallel verlaufend zum zweiten Schenkel (4) zwischen dem zweiten und dem dritten Schenkel (4, 5) angeordnet ist, wobei eine zum vierten Schenkel (6) gerichtete erste Fläche (31) des zweiten Schenkel (4) zusammen mit einer der ersten Fläche (31) gegenüberstehend angeordneten zweiten Fläche (32) des vierten Schenkels (6) ein viertes Befestigungsmittel (10) zum Befestigen eines Zusatzelementes (40) bilden.

3. Vorrichtung (1) nach Anspruch 2, wobei die sich gegenüberstehend angeordneten erste und zweite Fläche (31, 32) als eine das Gegenstück zu einem Schraubelement bildende Aufnahme ausgestaltet sind.

4. Vorrichtung (1) nach Anspruch 2, wobei die sich gegenüberstehend angeordneten erste und zweiten Fläche (31, 32) als eine das Gegenstück zu einem Verrastelement bildende Aufnahme ausgestaltet sind.

5. Vorrichtung (1) nach einem der Ansprüche 2 bis 4, wobei das Zusatzelement (40) abschnittsweise formschlüssig auf dem zweiten Befestigungsmittel (8) aufliegt.
